(19) **Europäisches Patentamt**
**European Patent Office**
**Office européen des brevets**

(11) **EP 0 622 823 B1**

(12) **EUROPEAN PATENT SPECIFICATION**

(45) Date of publication and mention
of the grant of the patent:
**23.07.1997 Bulletin 1997/30**

(51) Int Cl.⁶: **H01J 37/32**

(21) Application number: **94106586.4**

(22) Date of filing: **27.04.1994**

(54) **Sputtering targets having life alarm function**

Zerstäubungstarget mit Warneinrichtung

Cible de pulvérisation avec dispositif avertisseur

(84) Designated Contracting States:
**DE GB**

(30) Priority: **28.04.1993 JP 125067/93**

(43) Date of publication of application:
**02.11.1994 Bulletin 1994/44**

(73) Proprietor: **JAPAN ENERGY CORPORATION**
**Minato-ku, Tokyo (JP)**

(72) Inventors:
• **Sawada, Susumu, c/o Japan Energy Corporation**
**Minato-ku, Tokyo (JP)**
• **Anan, Junichi, c/o Japan Energy Corporation**
**Kitaibaraki-shi, Ibaraki-ken (JP)**

• **Nakamura, Hiroki c/o Oki Electr. Industry Co.,**
**Ltd**
**Minato-ku, Tokyo (JP)**
• **Sakaya, Yoshihiro, c/o Oki Electric Ind. Co., Ltd**
**Minato-ku, Tokyo (JP)**

(74) Representative: **Schwan, Gerhard, Dipl.-Ing.**
**Elfenstrasse 32**
**81739 München (DE)**

(56) References cited:
**DE-C- 3 630 737**          **GB-A- 2 199 340**
**US-A- 4 345 968**          **US-A- 4 374 722**
**US-A- 4 545 882**

## Description

[Industrial field of the invention]

This invention relates to sputtering targets having a lifealarm function and capable of preventing over-sputtering positively and reliably while keeping target use efficiency higher.

[Background of the invention]

The film-forming or film-depositing technology that utilizes the sputtering phenomenon caused by the glow discharge under a reduced pressure in the presence of dilute gas is now used in a broad range of applications including technological devices and equipment, electronic devices and equipment, and ornaments or decorations. As regards the sputtering targets used in that technology, many proposals have been made and varied types of targets suited for the individual applications are in use.

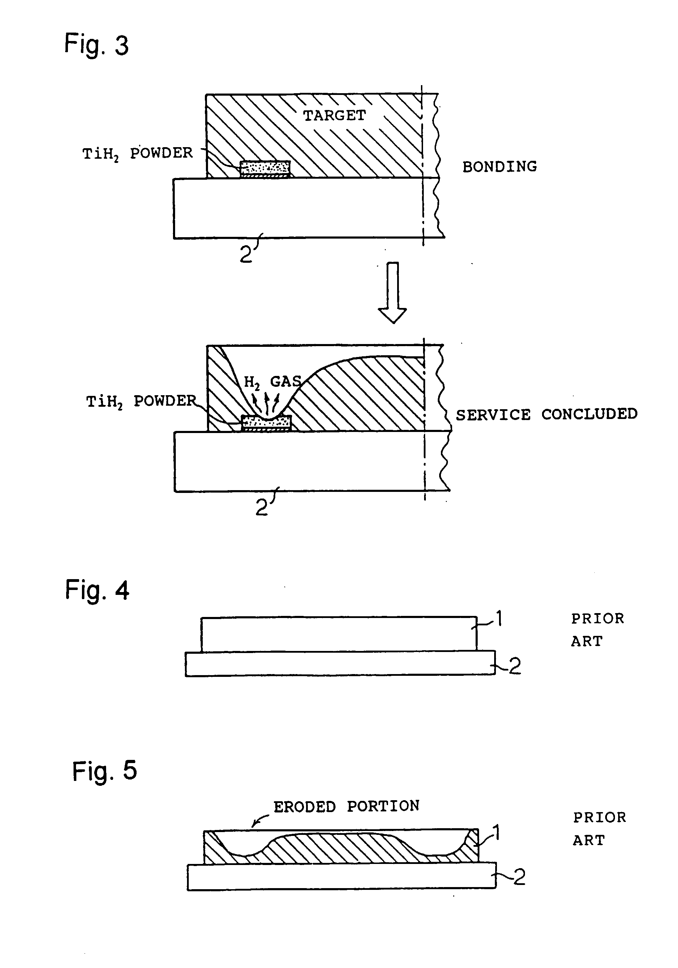

Sputtering targets usually are disk-shaped, and sputtering is carried out with each sputtering target 1 bonded to a water-cooled backing plate 2 of copper, as shown in FIG. 4.

As sputtering is continued, the target is consumed with the lapse of time, normally as indicated in FIG. 5. When the point where erosion has progressed most severely reaches a location near the bottom of the target, the life of the target is deemed to have expired and the target is replaced by a new one.

If the timing for replacing the sputtering target is too early, such a substantial part of the target is left unused that the target efficiency is poor. Conversely if the timing lags the target efficiency is improved but erosive attack of the backing plate (over-sputtering) can take place. For the practice of sputtering, therefore, precise judgment of the sputtering target life has been a very important requirement to be considered.

Whether a sputtering target in service is nearing the end of its life or not can hardly be directly determined visually or otherwise. It has been customary to use, as a measure of sputtering target life, the integrated electric power value that is closely related to the consumption of the target.

Specifically, with different types of sputtering targets the relations between their integrated electric power values and degrees of erosion are determined beforehand on the basis of actual past operation results. From the relations the critical values of integrated electric power that cause over-sputtering are calculated. Thus, it has been in practical that, at the point where the integrated electric power value during sputtering with a given target has reached a preset value near its critical value, the target life is judged to have expired and the target is replaced by a new one.

However, this practice has a problem of difficulty in determining the optimum preset value.

As stated already, the integrated electric power value indicative of the timing for replacement of a sputtering target has commonly been set in view of the relation between the integrated electric power value and the degree of erosion based upon past operation results. In reality, even target materials of the same kind often vary in density or in crystalline orientation and hence are eroded to varying degrees. Thus, strictly speaking, the relation between the integrated electric power value and the degree of erosion differs more or less with individual sputtering targets.

There have been few steps that can be taken to overcome the lower efficiency of sputtering targets, and not infrequently over-sputtering accident has taken place. The generation of defective target products and damage of manufacturing equipment due to over-sputtering, of course, involve a very large loss.

EP-A-0 615 273 which represents prior art according to Article 54(3) of the European Patent Convention for all designated states discloses a sputtering target provided with a conduit in which gas is entrapped. This gas source serves as an identifier present at a preselected target depth. Once gas is emitted from the gas source due to erosion of the target material above the gas source, the emission is detected using a gas composition analyzer or a pressure change indicator.

US-A-4 545 882 discloses a sputtering target with an detectable layer of detectable material underlying the target material. A support plates carries the detectable coating and the target material. When the target approaches depletion, the substrate to be sputtered will be sputtered with the detectable material, and this will be then detected a by detector as the substrate is transported from the sputtering chamber. The detectable material can be a radioactive substance, an electrical detectable substance such as iron, an optically detectable substance such as copper or gold which is highly reflective, or a fluorescent substance.

US-A-4 374 722 discloses a cylindrical sputtering cathode in a vacuum chamber, comprising a tubular target coaxially mounted around a tubular sheath. The tubular target is internally designed for closely fitting the respective end-shoulders of the tubular sheath. The coaxially mounted tubular sheath and tubular target delimitate a thin annular gas or vacuum tight chamber filled with a helium atmosphere of a pressure of about 13 mbar. Upon detection of a gas irruption inside the vacuum chamber, an automatic shut-off of the sputtering operation is controled.

[Object of the invention]

The present invention has for its object to establish means of predicting and determining the end of life of sputtering targets more precisely and in a simpler way than heretofore whereby over-sputtering can be positively prevented and the target use efficiency is enhanced.

[Summary of the invention]

After intensive investigations made from varied angles to attain the above object, the present inventors have now found the following: If a gas-component source (any element that evolves a gas component) is embedded in at least the bottom portion of a sputtering target of whatever kind at the location that is particularly susceptible to erosion, the gas source begins to produce a gas as the erosion of the target owing to sputtering progresses with decrease of remaining thickness of the target and reaches the gas source, with the consequence that the partial pressure of the gas and the degree of vacuum in the sputtering chamber change rapidly enough to be detected, allowing the end of life of the sputtering target to be sensed precisely.

The present invention has just been perfected on the basis of the above discovery. Thus, the present invention provides a sputtering target bonded to a backing plate having a life alarm function, the target containing a gas-component source in the bottom portion thereof, whereby the gas-component source is selected from the group consisting of a hydride of a metal, an organic material and a container in which a compressed gas is sealed.

[Brief explanation of the drawings]

FIG. 1 is a diagrammatic sectional view illustrating a sputtering target embodying the present invention.

FIG. 2 is an explanatory view showing the sequential cross sections of a half of a target for explaining a procedure of fabricating a sputtering target of the present invention.

FIG. 3 is an explanatory view showing the cross sections of a half of a sputtering target of the present invention at the time of bonding to a backing plate and at the time of the end of life of the sputtering target in use.

FIG. 4 is a front view of a sputtering target as bonded to a backing plate.

FIG. 5 is a sectional view explaining how a sputtering target is consumed.

[Explanation of the embodiments]

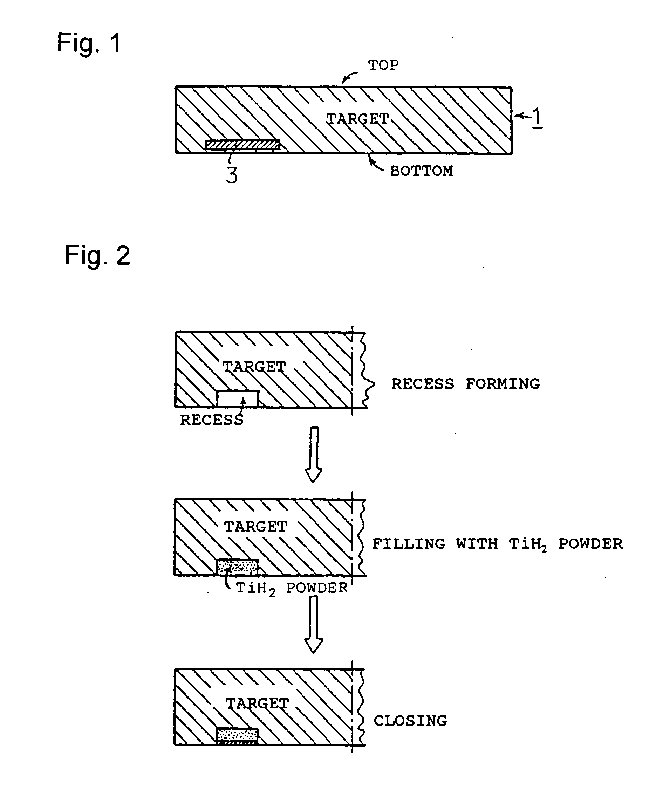

The present invention is principally characterized in that a sputtering target, as shown in FIG. 1, has a gas-component source (element capable of evolving a gas-component) 3 built in its bottom portion, whereby the expiration of lifetime of the target can be precisely sensed so as to prevent over-sputtering or a drop of the target use efficiency.

The sputtering targets to which the present invention is applicable may be of varied types, including those for VLSIs, magnetic and other applications. Needless to say, the materials are not specially restricted; the targets may be fabricated from any metal and its alloy such as Al, W, Mo, Ti, Ta, W-Ti alloy, Co-Ni alloy etc. and any silicide such as $MoSi_x$, $WSi_x$ etc..

The gas-component source (element capable of evolving a gas-component) is a hydride of a metal such as $TiH_2$ or $ZrH_2$ (in the form of powder, sintered body, etc.), organic material (anthraquinone, naphthacene, phenylalanine, etc.), or a container or ampul in which compressed gas is sealed.

The position in which a gas-component source is to be embedded or otherwise built in must be a bottom portion of a sputtering target at a depth where the gas evolution can be sensed at the point of time before over-sputtering takes place while the target use efficiency does not become poor. Preferably, the gas-component source is built in at any location in a thickness range of about one millimeter from the bottom surface of the target.

While the gas-component source may be built in the entire bottom portion of a sputtering target, it is more efficient to dispose the source only in the limited region of the bottom portion where the erosion that progresses with sputtering is expected to reach the deepest.

An example of fabrication of the sputtering target according to the present invention will now be explained as typified by a target in which $TiH_2$ powder is chosen as a gas-component source.

With the reference to FIG. 2, in a suitable sputtering target, a recess is made by mechanical means or the like at the bottom of the region where the deepest erosion is expected to occur. The recess is filled with $TiH_2$ powder.

Next, the recess is closed by appropriate means. This completes the fabrication of a sputtering target using $TiH_2$ powder as a gas-component source in accordance with the present invention. To close the recess, pouring a metal or alloy of low melting point, preferably In, into the remaining space of the recess is recommended.

Before this sputtering target is used in sputtering, it is bonded, as illustrated in FIG. 3, to a backing plate 2 in the usual manner.

With the lapse of sputtering, erosion progresses until it reaches the $TiH_2$ embedded at the bottom of the target. Then, the high temperature of the sputtering target causes a

$$TiH_2 \rightarrow Ti + H_2 \uparrow$$

reaction with the result that $H_2$ gas is released into the sputtering chamber.

Detection of this $H_2$ gas partial pressure enables the operator to know the expiration of life of the sputtering target. The end of target life can also be sensed by detecting the change in the degree of vacuum in the sputtering chamber with the release of $H_2$ gas.

In brief, the sputtering target with $TiH_2$ powder embedded in the bottom portion has a very desirable life alarm function.

Although the present invention has thus been described as incorporating TiH$_2$ powder as a gas-component source, similar effects are, of course, attainable with other metal hydrides, organic material as gas-component sources. Further, it should be quite obvious to those skilled in the art that embedding a container or ampul in which compressed gas is sealed is also equally effective.

[Example]

The present invention is illustrated by the following example.

To begin with, a pure Ti sputtering target in common use (292mm across and 10mm thick) was provided.

Next, as shown in FIG. 2, a recess 5mm in diameter and 1mm thick was formed at the bottom of the pure Ti sputtering target. The recess was filled with TiH$_2$ powder and closed with molten In.

Using this sputtering target, sputtering was performed. Prior to the sputtering, the target was bonded to a backing plate of copper by a conventional bonding process. The backed target was then set in a sputtering chamber and sputtering initiated.

As the sputtering with the target was continued, a quadrupole mass spectrometer (Q-MASS) that had been installed in the sputtering chamber detected a high concentration of H$_2$ gas. At that point the sputtering was concluded.

Following the conclusion of sputtering, the target was inspected. It was confirmed that the remaining thickness (below the level of the deepest erosion) of the target was 1mm, indicating that the target was consumed to attain a high material yield without any possibility of over-sputtering.

[Advantages of the invention]

According to the present invention, as described above, a sputtering target is provided which permits more accurate prediction and determination of the expiration of the target life than heretofore. It ensures the prevention of over-sputtering during sputtering operation and enhances the target use efficiency. With these and other advantages, the invention brings very useful effects from the industrial viewpoint.

## Claims

1. A sputtering target bonded to a backing plate (2) containing a gas-component source (3) in the bottom portion of the target for a life alarm function, said gas-component source being a hydride of a metal, an organic material or a container in which a compressed gas is sealed.

## Patentansprüche

1. Mit einer Trägerplatte (2) verbundenes Sputteringtarget, welches im unteren Bereich des Targets eine Gaskomponentenquelle (3) aufweist, die eine Lebensdauer-Alarmfunktion erfüllt und bei welcher es sich um ein Metallhydrid, ein organisches Material oder einen Behälter handelt, in welchem komprimiertes Gas eingeschlossen ist.

## Revendications

1. Cible pour pulvérisation liée à une plaque de soutien (2) contenant une source (3) d'un constituant gazeux dans la partie inférieure de la cible pour une fonction d'alarme de fin de vie, ladite source de constituant gazeux étant un hydrure d'un métal, une matière organique ou un récipient dans lequel un gaz comprimé est scellé.

## Fig. 1

TOP

TARGET ←1

3

BOTTOM

## Fig. 2

TARGET

RECESS FORMING

RECESS

TARGET

FILLING WITH $TiH_2$ POWDER

$TiH_2$ POWDER

TARGET

CLOSING

## Fig. 3

TiH$_2$ POWDER

TARGET

BONDING

2

TiH$_2$ POWDER

H$_2$ GAS

SERVICE CONCLUDED

2

## Fig. 4

1

2

PRIOR ART

## Fig. 5

ERODED PORTION

1

2

PRIOR ART